# FASCICULE DE BREVET EUROPEEN

(11) **EP 4 574 747 B1**
(45) Date de publication et mention de la délivrance du brevet: **09.09.2026**
(21) Numéro de dépôt: 24214452.5
(22) Date de dépôt: 21.11.2024
(51) Int. Cl.: B81C 1/00

(54) **PROCÉDÉ DE FABRICATION D'UNE STRUCTURE D'ENCAPSULATION**
VERFAHREN ZUR HERSTELLUNG EINER EINKAPSELUNGSSTRUKTUR
METHOD FOR MANUFACTURING PACKAGING STRUCTURE

(30) Priorité: 23.11.2023 FR 2312944
(43) Date de publication de la demande: 25.06.2025
(73) Titulaire: Commissariat à l'Energie Atomique et aux Energies Alternatives, 75015 Paris (FR)
(72) Inventeur: BERTHELOT, Audrey, 38054 Grenoble Cedex 09 (FR)
(74) Mandataire: Santarelli

(56) Documents cités:
- CN-A- 116 495 694
- "Handbook of Silicon Based MEMS Materials and Technologies", 22 February 2010, ELSEVIER SCIENCE & TECHNOLOGY BOOKS, ISBN: 978-0-81-551594-4, article ARI LEHTO ET AL: "PART V Encapsulation of MEMS Components", pages: 499 - 616, XP055750042

## Description

### DOMAINE TECHNIQUE

Le domaine de l'invention est celui de l'encapsulation d'un dispositif microélectronique, tel qu'un microsystème électromécanique (MEMS, ou « Micro-Electro Mechanical System » en anglais), ou un microsystème opto-électromécanique (MOEMS, ou « Micro-Opto-Electro Mechanical System » en anglais), ou un nanosystème électromécanique (NEMS, ou « Nano-Electro Mechanical System » en anglais), ou un nanosystème opto-électromécanique (NOEMS, ou « Nano-Opto-Electro Mechanical System » en anglais). L'invention concerne notamment l'encapsulation collective de dispositifs microélectroniques dans au moins une cavité de pression contrôlée.

### ÉTAT DE LA TECHNIQUE ANTÉRIEURE

Les dispositifs de la microélectronique sont généralement encapsulés pour les protéger d'éléments qui pourraient les endommager, comme l'humidité, une pollution particulaire, un gaz réactif tel que l'oxygène... Certains dispositifs de la microélectronique doivent en outre être encapsulés de façon hermétique dans une cavité à une pression prédéterminée et/ou contenant un gaz particulier.

Par exemple, un gyroscope de type MEMS nécessite d'être encapsulé hermétiquement à une pression inférieure à 10⁻¹ mbar (10 Pa), voire inférieure à 10⁻⁴ mbar (0,01 Pa). Un commutateur radiofréquence de type MEMS est généralement encapsulé hermétiquement dans un environnement gazeux neutre, à la pression atmosphérique, pour éviter une oxydation de zones de contact du commutateur. Typiquement, un accéléromètre de type MEMS mesure le déplacement d'une masse soumise à une accélération. La masse est une partie d'une structure suspendue. Pour obtenir une mesure précise de l'accélération, l'ensemble doit être amorti par une pression de gaz dans une cavité dans laquelle l'accéléromètre est encapsulé hermétiquement. La pression est par exemple au moins supérieure à 1 mbar (100 Pa). La pression permet de contrôler un facteur d'amortissement de la structure suspendue et/ou de la masse.

Il existe deux techniques alternatives pour encapsuler de façon hermétique un dispositif microélectronique réalisé sur et/ou dans un substrat.

Selon une première méthode, une couche mince est déposée sur une couche sacrificielle structurée emprisonnant le dispositif, et sur le substrat. La couche mince a une épaisseur typiquement comprise entre 0,1 µm et 5 µm. Au moins un évent traversant est pratiqué au travers de la couche mince. La couche sacrificielle est ensuite gravée et évacuée au travers l'évent. L'évent est ensuite bouché par un dépôt d'un matériau sous vide, par exemple par évaporation ou par un dépôt physique en phase vapeur. Le dispositif est alors encapsulé dans une cavité sous vide délimitée par un capot consistant en la couche mince et par le substrat. Cette méthode présente certains avantages, comme une bonne compacité, une bonne transmission du capot à un rayonnement électromagnétique...

Cependant, il est souvent préféré une deuxième méthode plus robuste et moins contraignante pour le choix des matériaux, ou le budget thermique, ou pour d'autres aspects. Elle comporte le scellement hermétique d'un capot ayant une épaisseur comprise entre 10 µm et quelques centaines de micromères, par exemple comprise entre 300 µm et 750 µm, ou encore entre 300 µm et 400 µm, sur le substrat, de manière à emprisonner le dispositif dans une cavité délimitée par le capot et le substrat. Le scellement peut être réalisé par différentes techniques parmi lesquelles, on peut citer : le collage moléculaire, le collage métallique, le scellement anodique, et le scellement par verre fritté.

Un exemple de procédé de fabrication d'une structure d'encapsulation selon la deuxième méthode est enseigné dans le document WO2015/119564. Celui-ci permet d'encapsuler hermétiquement plusieurs dispositifs d'une même puce, chacun dans une cavité hermétique distincte, de pression interne contrôlée. Des évidements sont pratiqués dans un capot. Ils sont destinés à délimiter, chacun, une cavité. Un élément structurel est ensuite formé dans un évidemment. L'élément structurel comprend des ions, des atomes ou des molécules d'un gaz, qui sont piégés, absorbés ou adsorbés. Le capot est scellé sous vide à un substrat comprenant des dispositifs microélectroniques de façon à emprisonner chaque dispositif dans une cavité distincte. Une structure d'encapsulation est ainsi obtenue. Un chauffage subséquent permet de libérer le gaz de l'élément structurel dans la cavité le contenant, ainsi une pression supérieure à la pression de l'étape de scellement peut être obtenue dans cette cavité.

En figures 9 et 10 du document WO2015/119564, l'élément structurel peut être un métal obtenu par un dépôt physique en phase vapeur utilisant de l'argon comme gaz porteur. Le métal contient alors de l'argon. Ce dernier est libéré dans la cavité par un chauffage intervenant après le scellement. Ainsi une pression prédéterminée peut être obtenue dans la cavité. Il est possible d'atteindre deux pressions différentes dans deux cavités distinctes en déposant deux éléments structurels en métal différents dans deux évidements distincts du capot, lors de deux étapes de dépôt distinctes conduisant à une concentration d'argon différente dans un élément structurel par rapport à l'autre.

Le procédé de fabrication du document WO2015/119564 est cependant complexe à mettre en œuvre, nécessite de nombreuses étapes et conduit à une structure d'encapsulation assez volumineuse.

Des exemples de méthodes de scellement collectif de microcavités à des pressions différentes peuvent être trouvées dans le document CN 116 495 694 A. La partie V « Encapsulation of MEMS Components » du manuel de Ari Lehto et al. « Handbook of Silicon Based MEMS Materials and Technologies » , 22 février 2010, Elsevier Science & Technology Books, décrit au chapitre 34 des méthodes de scellement par alliage métallique utiles à la réalisation de microcavités hermétiques.

### EXPOSÉ DE L'INVENTION

L'invention a pour objectif de remédier au moins en partie aux inconvénients de l'art antérieur, et plus particulièrement de proposer un procédé de fabrication simplifié d'une structure d'encapsulation comprenant au moins deux cavités hermétiques. Le procédé de fabrication résulte en une structure d'encapsulation plus compacte que l'art antérieur.

Pour cela, l'objet de l'invention est un procédé de fabrication d'une structure d'encapsulation comprenant une première cavité et une deuxième cavité, toutes deux hermétiques, le procédé comportant une étape de formation sur un substrat d'une première portion d'un matériau apte à libérer un gaz noble contenu dans le matériau par chauffage, destinée à constituer une paroi de la première cavité ; une étape de formation d'une deuxième portion (105b) du matériau sur le substrat (100) ou sur un capot (200), destinée à constituer une paroi de la deuxième cavité (300b) ; une étape de scellement du substrat au capot pour former et fermer hermétiquement sous une pression commune, chacune des première et deuxième cavités ; une étape de chauffage de la première et deuxième cavités pour libérer le gaz noble contenu dans le matériau. Le procédé est tel que la première portion et la deuxième portion participent au scellement du substrat au capot lors de l'étape de scellement, et tel que la paroi de la première cavité constituée par la première portion a une première surface rapportée au volume de la première cavité strictement supérieure à une deuxième surface de la paroi de la deuxième cavité constituée par la deuxième portion rapportée au volume de la deuxième cavité.

Certains aspects préférés mais non limitatifs de ce procédé de fabrication sont les suivants.

L'étape de scellement peut être réalisée par un alliage eutectique ou par thermocompression, et peut comprendre l'étape de chauffage.

L'étape de scellement peut être effectuée sous un vide poussé de pression inférieure à 0,1 Pa, préférentiellement inférieure à 0,001 Pa.

L'étape de formation de la première portion peut comprendre un dépôt de type PVD ou IBD en présence d'un gaz porteur de même nature que le gaz noble.

La deuxième portion peut être formée sur le substrat, en même temps que la formation de la première portion lors de l'étape de formation.

Le procédé de fabrication peut comprendre en outre une étape de formation d'une portion d'un matériau de type getter non évaporable sur le substrat ou le capot, destinée à constituer une paroi de la deuxième cavité, et la portion de matériau getter peut être activée lors de l'étape de chauffage.

La structure d'encapsulation peut comprendre en outre une troisième cavité hermétique, dans lequel une troisième portion du matériau peut être formée sur le substrat, en même temps que la première portion et la deuxième portion lors de l'étape de formation, de façon à ce que la troisième portion constitue une paroi de la troisième cavité ayant une troisième surface comprise strictement entre la première surface et la deuxième surface, la troisième portion pouvant participer au scellement du substrat au capot lors de l'étape de scellement.

Le matériau peut être choisi parmi le germanium, l'or, un alliage d'aluminium et de silicium et un alliage d'aluminum et de cuivre.

Le procédé de fabrication peut comprendre en outre, préalablement à l'étape de scellement, une étape de creusement d'un évidement dans le substrat et/ou le capot destiné à constituer des parois de la première et/ou la deuxième cavité.

Le procédé de fabrication peut comprendre en outre, préalablement à l'étape de scellement, une étape de réalisation d'un premier dispositif microélectronique dans et/ou sur le substrat et/ou le capot destiné à être emprisonné dans la première cavité, et une étape de réalisation d'un deuxième dispositif microélectronique dans et/ou sur le substrat et/ou le capot destiné à être dans la deuxième cavité.

Le premier dispositif microélectronique peut être un accéléromètre et le deuxième dispositif microélectronique peut être un gyroscope.

Le procédé de fabrication peut comprendre en outre, préalablement à l'étape de scellement, une étape de réalisation d'un accéléromètre dans et/ou sur le substrat et/ou le capot destiné à être emprisonné dans la troisième cavité.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figure 1A et 1B sont des vues schématiques en coupe d'étapes de fabrication de dispositifs microélectroniques ;
les figures 2A à 2C sont des vues schématiques en coupe d'étapes de fabrication d'un capot ;
les figures 3A et 3B sont des vues schématiques en coupe d'étapes de fabrication d'une structure d'encapsulation ;
les figures 4A à 4E sont des vues schématiques en coupe d'exemples non limitatifs de structures intermédiaires pouvant être mises en œuvre dans le procédé de l'invention.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'une structure d'encapsulation comprenant au moins deux cavités. Le procédé comprend une étape de scellement d'un substrat et d'un capot par au moins une portion d'un matériau comportant des atomes d'un gaz noble, pouvant être piégés, absorbés ou adsorbés par le matériau. La portion constitue une paroi d'une cavité. Une étape de chauffage, qui peut être avantageusement une sous-étape du scellement, permet de libérer le gaz noble par la paroi constituée par la portion dans la cavité. La surface de la paroi constituée par la portion est choisie pour libérer une quantité de gaz noble prédéterminée. Ainsi, la portion assure au moins trois fonctions, à savoir le scellement, la délimitation de la cavité, ainsi que la définition de son volume, et la régulation d'une pression interne de la cavité, ou l'introduction d'un gaz noble particulier. La structure d'encapsulation issue du procédé de l'invention est alors compacte, et nécessite moins d'étapes de procédé.

Le procédé de l'invention permet d'encapsuler en même temps plusieurs dispositifs d'une même plaque avant découpe en plusieurs puces électroniques indépendantes. Dans ce cas, il s'agit d'un procédé d'encapsulation collectif qui peut être une brique essentielle d'un procédé de conditionnement collectif incluant par exemple des connections électriques vers un PCB ou un autre support. Cette famille de conditionnement collectif est connue sous le sigle WLP, pour « Wafer Level Packaging » en anglais.

Dans toute la description, on appelle un gaz noble, un gaz chimiquement inerte, c'est-à-dire qu'il n'établit pas de liaison covalente avec d'autres atomes. Les éléments du groupe 18 du tableau périodique des éléments sont des exemples de gaz nobles. Un gaz noble satisfaisant pour l'invention peut être, par exemple, de l'hélium, du néon, de l'argon, du krypton, du xénon, du radon, ou un mélange de ces gaz.

Dans toute la description, une cavité est un volume fermé de toute part contenant un gaz, de l'air ou du vide. La cavité est hermétique si un gaz ne peut s'échapper ou s'introduire dans le volume fermé. Le volume fermé est délimité par des parois de la cavité.

Par couche, on entend une étendue d'un matériau dont l'épaisseur suivant un axe Z est inférieure, par exemple dix fois, voire vingt fois, à ses dimensions longitudinales de largeur et de longueur dans un plan (X, Y) perpendiculaire à l'axe Z.

Des modes de réalisation particuliers vont être à présent décrits, se rapportant à un procédé de fabrication d'une structure d'encapsulation comportant au moins deux cavités. Cependant, ces modes de réalisation peuvent être adaptés pour réaliser toute autre structure emprisonnant un gaz dans une cavité hermétique.

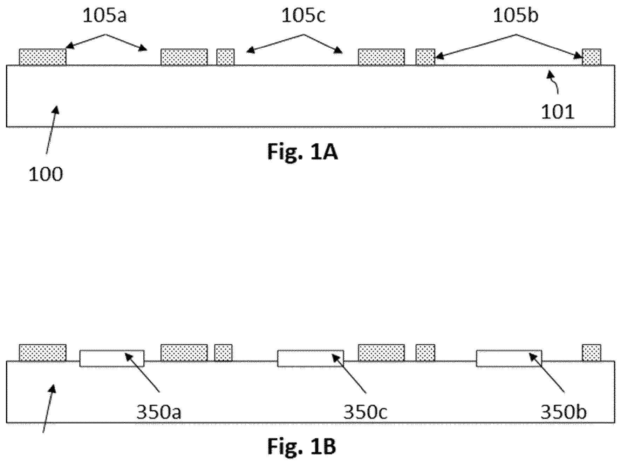

En figure 1A, une première couche d'un matériau, dit matériau chargé, apte à libérer un gaz noble par chauffage est déposée sur une première face 101 d'un substrat 100. Sur les figures, la présence d'un gaz noble dans une couche ou une portion est matérialisée par un remplissage représentant une matrice de points.

Le substrat 100 peut être par exemple une plaque, comme une plaque de type silicium sur isolant (ou SOI, pour « Silicon On Insulator », en anglais), par exemple de diamètre 150 mm, 200 mm ou 300 mm. Alternativement ou en complément, le substrat 100 peut comprendre des composants d'un circuit électronique, comme des transistors et/ou des interconnexions métalliques. Le matériau chargé comprend des ions, des atomes ou des molécules du gaz noble, qui peuvent être piégés, absorbés ou adsorbés. Il est composé d'une matrice et du gaz noble, c'est-à-dire qu'il consiste en la matrice et le gaz noble. Le matériau chargé comprend essentiellement un métal ou un semiconducteur. La présence de gaz noble dans le matériau chargé résulte du procédé de dépôt mis en œuvre.

Le substrat 100 est imperméable aux gaz. Il a une épaisseur selon une direction perpendiculaire à la première face 101, comprise entre 10 µm et quelques centaines de micromères, par exemple comprise entre 300 µm et 750 µm, ou encore entre 300 µm et 400 µm. Le matériau chargé peut comprendre essentiellement de l'or, du cuivre, du titane, de l'aluminium, de l'étain, du silicium, du germanium, un alliage d'aluminium et de silicium, ou un alliage d'aluminium et de cuivre, ou un mélange de ces composés.

Ici, et dans toute la description, un matériau, une portion ou une couche comprend essentiellement (respectivement majoritairement) un composé, si le matériau, la portion ou la couche comporte moins de 10% (respectivement moins de 50%) d'éléments différents du composé et différents d'atomes du gaz noble d'intérêt. Une couche comprend essentiellement (respectivement majoritairement) un groupe de composés ou un mélange de composés, si le matériau, la portion ou la couche comporte moins de 10% (respectivement moins de 50%) d'éléments différents du groupe de composés ou du mélange de composés et différents d'atomes du gaz noble d'intérêt. Lorsqu'un matériau est choisi parmi un groupe de composés, on entend que le matériau comprend essentiellement le composé choisi.

La première couche est par exemple déposée dans une chambre par un dépôt physique en phase vapeur (ou PVD pour Physical Vapor Deposition en anglais) à l'aide d'un plasma comprenant le métal ou le semiconducteur et un gaz porteur de même nature que le gaz noble. Le gaz porteur est, par exemple, de l'hélium, du néon, de l'argon, du krypton, du xénon, du radon, ou un mélange de ces gaz. Ainsi, des atomes de gaz noble sont piégés dans la première couche. Une pression et/ou une concentration de gaz porteur dans la chambre permettent d'ajuster une quantité d'atomes de gaz noble piégée dans le matériau chargé. Il est par exemple possible de déposer par PVD de l'aluminium avec un plasma d'argon et/ou de krypton, en plus de l'aluminium. Il est également possible de déposer par PVD de l'or avec un plasma d'argon et/ou de krypton et/ou d'azote, en plus de l'or.

Alternativement, la première couche peut être déposée par une technique de dépôt par faisceau d'ions (IBD, pour « Ion Beam Deposition » en anglais), ou par pulvérisation par faisceau d'ions (IBS, pour « Ion Beam Sputtering » en anglais). Ces techniques de dépôt impliquent typiquement le bombardement d'une cible comportant le métal ou le semiconducteur par un faisceau d'ions de pulvérisation. La cible et le substrat 100 sont placés dans une chambre de dépôt sous vide. Un faisceau d'ions d'assistance peut optionnellement intervenir au moment du dépôt. Un neutraliseur introduisant un gaz neutre dans la chambre, est souvent utilisé pour éviter que des surfaces isolantes de la chambre ou d'éléments isolants situés dans la chambre ne se chargent sous l'effet par exemple des faisceaux d'ions de pulvérisation et d'assistance. Les faisceaux d'ions de pulvérisation et, le cas échéant d'assistance, peuvent comprendre des atomes d'un gaz noble, comme par exemple l'argon, le krypton ou le xenon. Le gaz neutre du neutraliseur peut être de l'argon, qui est un gaz noble. Ainsi, une partie au moins du faisceau d'ions de pulvérisation et/ou le faisceau d'ions d'assistance et/ou du gaz neutre constitue un gaz porteur de même nature que le gaz noble, et des atomes de gaz noble sont piégés dans la première couche. Des paramètres du dépôt permettent d'ajuster une quantité d'atomes de gaz noble piégée dans le matériau chargé, comme par exemple une pression de la chambre de dépôt, des orientations angulaires du substrat 100, de la cible, des faisceaux d'ions de pulvérisation et d'assistance, une énergie des faisceaux d'ions de pulvérisation et d'assistance.

La première couche est ensuite gravée localement, par exemple par gravure sèche au travers d'un masque, pour réaliser au moins une première portion 105a. Ici, une deuxième portion 105b et une troisième portion 105c sont également réalisées au cours de cette étape. La première couche est par exemple gravée sur toute son épaisseur pour exposer localement la première face 101 du substrat 100. Comme cela est représenté en figure 1A, les première, deuxième et troisième portions 105a, 105b, 105c peuvent être dissociées, c'est-à-dire qu'elles ne sont pas en contact. L'une quelconque des première, deuxième et troisième portions 105a, 105b, 105c peut aussi être en contact physique, c'est-à-dire jointive, avec une autre portion parmi les première, deuxième et troisième portions 105a, 105b, 105c dans une région destinée à être une région inter-cavités 320 de la structure d'encapsulation 1, c'est à dire que la première couche n'a pas été gravée dans la région inter-cavités 320.

Les première, deuxième et troisième portions 105a, 105b, 105c sont destinées à constituer, respectivement, des parois de première, deuxième et troisième cavités 300a, 300b, 300c distinctes. Dans cet exemple, les première, deuxième et troisième portions 105a, 105b, 105c sont formées en même temps, c'est-à-dire que leurs formations respectives découlent des mêmes étapes de procédé comprenant le dépôt et la gravure de la première couche.

En figure 1B, on réalise un premier dispositif microélectronique 350a, un deuxième dispositif microélectronique 350b et un troisième dispositif microélectronique 350c dans le substrat 100 et/ou sur la première face 101 du substrat 100. Des étapes de réalisation des premier, deuxième et troisième dispositifs microélectroniques 350a, 350b, 350c peuvent comprendre des sous-étapes communes. Chaque dispositif microélectronique parmi le premier, le deuxième et le troisième dispositif microélectronique 350a, 350b, 350c a une partie fonctionnelle devant être exposée à une pression de gaz et/ou à un gaz particulier. La partie fonctionnelle du premier, du deuxième et du troisième dispositif microélectronique 350a, 350b, 350c est destinée à être exposée à l'intérieur, respectivement, des première, deuxième et troisième cavités 300a, 300b, 300c.

Ici, la première portion 105a entoure le premier dispositif microélectronique 350a dans toutes les directions d'un plan sensiblement parallèle à la première face 101 du substrat. Les deuxième et troisième portions 105b, 105c entourent respectivement les deuxième et troisième dispositifs microélectroniques 350b dans toutes les directions du plan. Ainsi, les première, deuxième et troisième portions 105a, 105b, 105c constituent des cordons, dits de scellement, autour, respectivement, des premier, deuxième et troisième dispositifs microélectroniques 350a, 350b, 350c.

Dans cet exemple, le premier dispositif microélectronique 350a est un accéléromètre et le troisième dispositif microélectronique 350c est un accéléromètre additionnel. Le deuxième dispositif microélectronique 350b est un gyroscope.

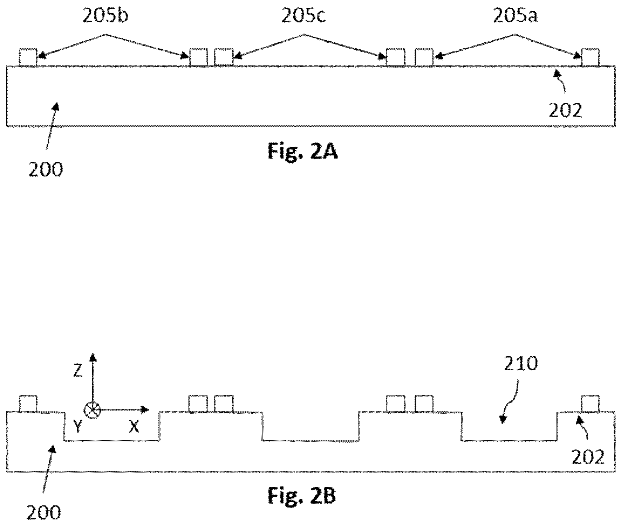

En figure 2A, une deuxième couche en un matériau, dit matériau complémentaire, est déposée sur une deuxième face 202 d'un capot 200. Le matériau complémentaire est apte à coller, et/ou à fusionner, et/ou à créer un alliage avec le matériau chargé lorsqu'il est mis en contact avec le matériau chargé, éventuellement via l'apport d'une source d'énergie externe, comme une étape de chauffage, ou l'application d'une force mécanique, ou éventuellement les deux. Le matériau complémentaire peut être de même nature que la matrice du matériau chargé ou être le même que le matériau chargé. Le matériau complémentaire peut lui-même être apte à libérer un gaz noble additionnel par chauffage, identique ou différent du gaz noble contenu dans le matériau chargé. Il peut alors être obtenu par une des techniques de dépôt utilisables pour déposer la première couche.

Le capot 200 est imperméable aux gaz, il comprend par exemple essentiellement un semiconducteur. Il a une épaisseur selon une direction perpendiculaire à la deuxième face 202, comprise entre 10 µm et quelques centaines de micromères, par exemple comprise entre 300 µm et 750 µm, ou entre 300 µm et 400 µm. Lorsque le substrat 100 est une plaque en forme de disque, le capot 200 peut par exemple être une plaque en forme de disque de même diamètre que le substrat 100. La deuxième couche peut être, par exemple, de l'or, du cuivre, du titane, de l'aluminium, de l'étain, du silicium, du germanium, un alliage d'aluminium et de silicium, ou un alliage d'aluminium et de cuivre.

La deuxième couche est ensuite gravée localement, par exemple par gravure sèche au travers d'un masque, pour réaliser au moins une première portion complémentaire 205a. Ici, une deuxième portion complémentaire 205b et une troisième portion complémentaire 205c sont également réalisés au cours de cette étape. La deuxième couche est par exemple gravée sur toute son épaisseur pour exposer localement la deuxième face 202 du capot 200. Ici, les première, deuxième et troisième portions complémentaires 205a, 205b, 205c sont positionnées et dimensionnées pour reposer en intégralité, respectivement, sur les première, deuxième et troisième portions 105a, 105b, 105c lorsque le capot 200 est mis en regard du substrat 100.

Tout comme pour les première, deuxième et troisième portions 105a, 105b, 105c, les première, deuxième et troisième portions complémentaires 205a, 205b, 205c peuvent être dissociées, comme cela est représenté en figure 2A ou jointives.

On définit ici et pour la suite de la description un repère direct tridimensionnel orthogonal (X, Y, Z), où les axes X et Y forment un plan parallèle au plan principal du capot 200, et où l'axe Z est orienté de manière sensiblement orthogonale au plan principal du capot 200, depuis une face opposée à la deuxième face 202, vers la deuxième face 202. Si le capot est une plaque comportant un repère en forme d'encoche ou de méplat, l'axe X est dirigé depuis le centre de la plaque vers le repère. Dans la suite de la description, les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan (X, Y). Par ailleurs, les termes « inférieur » et « supérieur » s'entendent comme étant relatifs à un positionnement croissant lorsqu'on s'éloigne du capot 200 suivant la direction +Z.

En figure 2B, on grave des évidements 210 dans le capot 200 qui s'étendent dans le capot 200 depuis la deuxième face 202 sur une profondeur par exemple comprise entre 5 µm et 500 µm. Il est possible d'utiliser par exemple une gravure humide à base de KOH, ou une gravure sèche. Chaque évidement 210 est destiné à être une paroi de l'une parmi les première, deuxième et troisième cavités 300a, 300b, 300c.

Ici, chaque première, deuxième ou troisième portion complémentaires 205a, 205b, 205c entoure un évidement 210 dans toutes les directions d'un plan sensiblement parallèle au plan (X, Y). Ainsi, les première, deuxième et troisième portions complémentaires 205a, 205b, 205c constituent des cordons de scellement, autour d'un évidement 210.

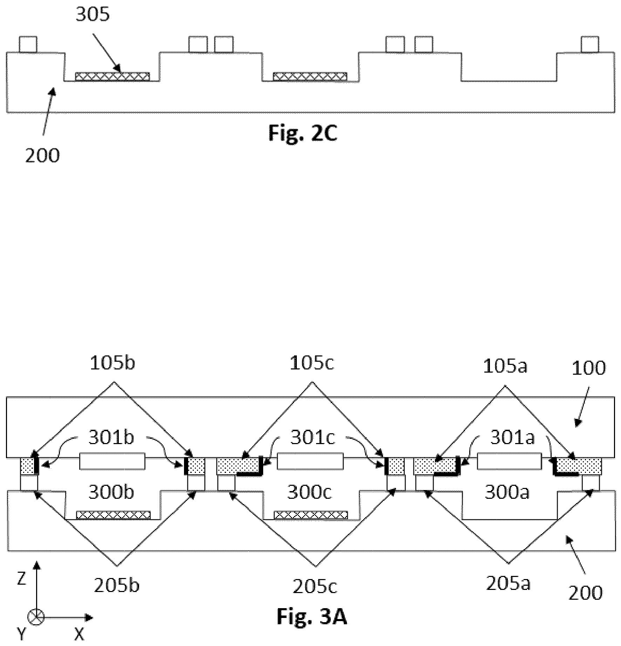

En figure 2C, une portion d'un matériau getter 305 non évaporable est optionnellement formée sur un fond d'au moins un évidement 210, à l'aide d'étapes de dépôt, de photolithographie et de gravure classiques de l'industrie de la microélectronique. Ici, deux portions d'un matériau getter 305 non évaporable ont été formées dans deux évidements 210 respectifs.

Un matériau getter non évaporable est un matériau qui peut capturer des molécules de gaz chimiquement actifs en formant des liaisons chimiques stables avec les gaz sur une surface du matériau getter. Des gaz chimiquement actifs sont par exemple : H₂, O₂, N₂, H₂O, CO et CO₂. Les gaz nobles ne réagissent pas chimiquement avec la surface. Ils ne sont donc pas adsorbés par le matériau getter. Le matériau getter peut comporter une ou plusieurs couches comprenant chacune majoritairement du titane, du zirconium ou du chrome, ou un mélange de ces matériaux.

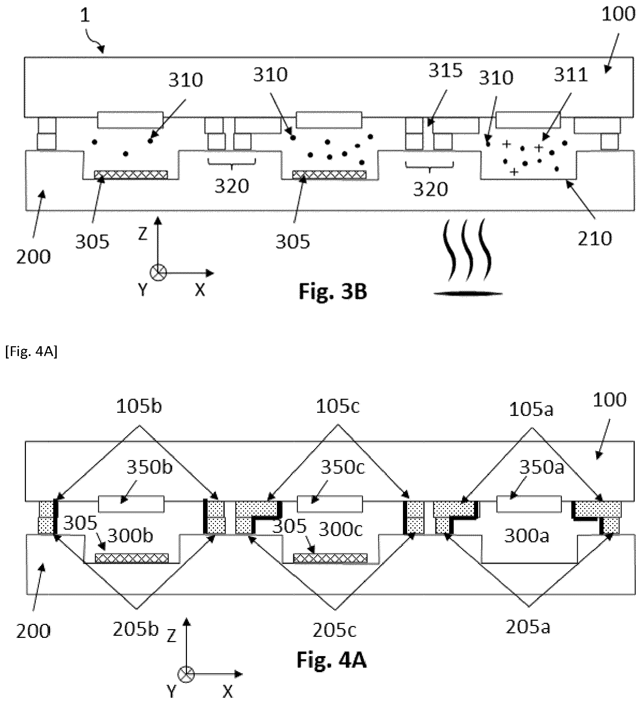

Les figures 3A et 3B représentent une étape de scellement dans une enceinte sous vide poussé. Le substrat 100 est reporté sur le capot 200 de sorte à mettre respectivement en contact les première, deuxième et troisième portions 105a, 105b, 105c avec les première, deuxième et troisième portions complémentaires 205a, 205b, 205c. Une pression de gaz dans l'enceinte est par exemple inférieure à 10⁻³ mbar (0,1 Pa), voire inférieure à 10⁻⁵ mbar (0,001 Pa) pendant l'étape de scellement.

La première portion 105a et la première portion complémentaire 205a ferme alors la première cavité 300a délimitée par la première portion 105a, la première portion complémentaire 205a, le capot 200 et le substrat 100. Une paroi de la première cavité 300a est constituée par un parmi les évidements 210. De même, la deuxième portion 105b et la deuxième portion complémentaire 205b ferme la deuxième cavité 300b délimitée par la deuxième portion 105b, la deuxième portion complémentaire 205b, le capot 200 et le substrat 100. La troisième portion 105c et la troisième portion complémentaire 205c ferme la troisième cavité 300c délimitée par la troisième portion 105c, la troisième portion complémentaire 205c, le capot 200 et le substrat 100. La pression à l'intérieure des première, deuxième et troisième cavités 300a, 300b, 300c est alors sensiblement égale à la pression de l'enceinte.

Une première surface 301a de la première portion 105a à l'intérieur de la première cavité 300a constitue une paroi de la première cavité 300a (en trait gras sur la figure 3A). De façon similaire, une deuxième surface 301b de la deuxième portion 105b à l'intérieur de la deuxième cavité 300b constitue une paroi de la deuxième cavité 300b. Et, une troisième surface 301c de la troisième portion 105c à l'intérieur de la troisième cavité 300c constitue une paroi de la troisième cavité 300c. Les première, deuxième et troisième portions 105a, 105b, 105c et les première, deuxième et troisième portions complémentaires 205a, 205b, 205c sont agencées et dimensionnées de manière à ce que la première surface 301a soit strictement supérieure à la troisième surface 301c, et à ce que la troisième surface 301c soit strictement supérieure à la deuxième surface 301b.

Dans cet exemple, les première et troisième surfaces 301a, 301c comprennent chacune une face inférieure, appelée débordement, sensiblement plane et parallèle au plan (X, Y), entourant une région centrale dans laquelle se trouve, respectivement, le premier et le troisième dispositifs microélectroniques 350a, 350c. Les première et troisième surfaces 301a, 301c comprennent également chacune une face interne sensiblement orthogonale au plan (X, Y) entourant également la région centrale respective. La deuxième surface 301b est dépourvue de débordement, elle a donc une aire minimale.

Ici et dans toute la description, quand on compare deux surfaces entre elles, on entend comparer les aires de ces surfaces. Ainsi, par « la première surface 301a est strictement supérieure à la troisième surface 301c », on entend que l'aire de la première surface 301a est strictement supérieure à l'aire de la troisième surface 301c.

On définit une région inter-cavités 320 comme étant une région externe aux cavités, s'étendant selon l'axe Z entre la première face 101 du substrat 100 et la deuxième face 202 du capot 200, et selon un plan parallèle au plan (X, Y) entre deux parois internes de deux cavités contigües. Dans cet exemple, une région inter-cavités 320 entre la première cavité 300a et la troisième cavité 300c comprend un espace 315 entre d'une part la première portion 105a et la première portion complémentaire 205a, et d'autre part la troisième portion 105c et la troisième portion complémentaire 205c. Cet espace 315 permet éventuellement de dissocier une puce comprenant le premier dispositif microélectronique 350a d'une autre puce comprenant le troisième dispositif microélectronique 350c par découpe à l'aide d'une scie au niveau de l'espace 315.

En figure 3B, un chauffage à une température T_{C} permet de sceller hermétiquement les première, deuxième et troisième cavités 300a, 300b, 300c et de libérer le gaz noble 310, c'est-à-dire que la température T_{C} est suffisante pour libérer une partie au moins du gaz noble 310 du matériau chargé. La quantité d'atomes de gaz noble libérée croit avec la surface de paroi constituée de matériau chargé. Ainsi, comme la première surface 301a est strictement supérieure à la troisième surface 301c, la quantité d'atomes de gaz noble 310 libérée dans la première cavité 300a est strictement supérieure à la quantité d'atomes de gaz noble 310 libérée dans la troisième surface 301c. De même, la quantité d'atomes dans la troisième cavité 300c est strictement supérieure à la quantité d'atomes de gaz noble 310 de la deuxième cavité 300b. Ici, les première, deuxième et troisième cavités 300a, 300b, 300c ont des volumes sensiblement égaux. Par conséquent, à l'issue du chauffage, la pression partielle de gaz noble dans la première cavité 300a est strictement supérieure à la pression partielle de gaz noble dans la troisième cavité 300c, qui est strictement supérieure à la pression partielle de gaz noble dans la deuxième cavité 300b.

Les parties fonctionnelles respectives des premier, deuxième et troisième dispositifs microélectroniques 350a, 350b, 350c sont exposées à l'intérieur, respectivement, des première, deuxième et troisième cavités 300a, 300b, 300c, c'est-à-dire qu'ils sont encapsulés ou emprisonnés dans une cavité distincte parmi les première, deuxième et troisième cavités 300a, 300b, 300c.

Le volume des première, deuxième et troisième cavités 300a, 300b, 300c est par exemple égal à 34.10⁶ µm³. La différence entre la troisième surface 301c et la deuxième surface 301b peut être au moins supérieure à 18.10³ µm², ou supérieure à 37.10³ µm², préférentiellement supérieure à 70.10³ µm². De même, la différence entre la deuxième surface 301b et la troisième surface 301c peut être au moins supérieure à 18.10³ µm², ou supérieure à 37.10³ µm², préférentiellement supérieure à 70.10³ µm². Les première, deuxième et troisième portions 105a, 105b, 105c et les première, deuxième et troisième portions complémentaires 205a, 205b, 205c ont des épaisseurs mesurées le long de l'axe Z comprises entre 10 nm et 5 µm, par exemple comprises entre 100 nm et 1 µm, par exemple égales à 500nm. Les épaisseurs des première, deuxième et troisième portions 105a, 105b, 105c sont par exemple sensiblement égales à une première épaisseur commune. De même, les épaisseurs des première, deuxième et troisième portions complémentaires 205a, 205b, 205c peuvent être égales à une deuxième épaisseur commune. La première épaisse commune peut être égale ou différente de la deuxième épaisseur commune.

La température T_{C} est avantageusement suffisante pour activer les portions de matériau getter 305 pendant l'étape de scellement. Ainsi, des atomes ou des molécules d'autres gaz 311 chimiquement actifs présents dans la deuxième cavité 300b et la troisième cavité 300c sont adsorbés par les portions de matériau getter 305, et la pression dans les deuxième et troisième cavités 300b, 300c est diminuée. Les atomes de gaz noble 310 ne sont en revanche pas adsorbés par les portions de matériau getter 305.

La température T_{C} est par exemple supérieure à 300 °C pendant une durée comprise 1 minute et 1 heure, ou 15 minutes et 45 minutes, par exemple égale à 30 minutes.

Un scellement par un alliage eutectique ou un scellement par thermocompression permettent à la fois de libérer le gaz noble des première, deuxième et troisième portions 105a, 105b, 105c et d'activer les portions de matériau getter 305. Alternativement, il est possible de réaliser un autre type de scellement, comme par exemple un scellement moléculaire métal-métal à basse température, et effectuer le chauffage pour libérer le gaz noble des première, deuxième et troisième portions 105a, 105b, 105c et un chauffage pour activer les portions d'un matériau getter 305 lors d'une étape commune ou plusieurs étapes ultérieures. Dans le cas d'un scellement moléculaire métal-métal, les première, deuxième et troisième portions 105a, 105b, 105c et les première, deuxième et troisième portions complémentaires 205a, 205b, 205c comprennent par exemple toutes essentiellement du titane, ou de l'or, ou du cuivre.

Dans le cas d'un scellement par un alliage eutectique, le matériau chargé peut comprendre essentiellement du germanium (respectivement de l'aluminium) et les première, deuxième et troisième portions complémentaires 205a, 205b, 205c peuvent comprendre essentiellement de l'aluminium. La température de chauffage T_{C} est alors supérieure ou égale à 425°C, voire supérieure ou égale à 450 °C.

Toujours dans le cas d'un scellement par un alliage eutectique, le matériau chargé peut comprendre essentiellement de l'or (respectivement du silicium) et les première, deuxième et troisième portions complémentaires 205a, 205b, 205c peuvent comprendre essentiellement du silicium (respectivement de l'or). La température de chauffage T_{C} est alors supérieure ou égale à 400 °C.

Selon un autre exemple de scellement par un alliage eutectique, le matériau chargé peut comprendre essentiellement de l'or (respectivement de l'étain) et les première, deuxième et troisième portions complémentaires 205a, 205b, 205c peuvent comprendre essentiellement de l'étain (respectivement de l'or). La température de chauffage T_{C} est alors supérieure ou égale à 300 °C.

Une portion d'un matériau getter 305 comprenant majoritairement du titane est activé à une température supérieure ou égale à 350°C.

Dans cet exemple, le gyroscope est emprisonné dans la deuxième cavité 300b à une pression proche de la pression de l'enceinte du fait que la deuxième surface 301b a une aire minimale et par l'action de la portion de matériau getter activé 305. La pression résultante dans la deuxième cavité 300b est par exemple comprise entre 10⁻⁴ mbar (0,01 Pa) et 0,1 mbar (10 Pa), voire comprise entre 10⁻⁴ mbar (0,01 Pa) et 10⁻³ mbar (0,1 Pa). Le gyroscope peut donc fonctionner correctement.

L'accéléromètre additionnel est emprisonné dans la troisième cavité 300c à une pression strictement supérieure à la pression de l'enceinte et strictement supérieure à la pression de la deuxième cavité 300b. La pression résultante dans la troisième cavité 300c est par exemple comprise entre 0,1 mbar (10 Pa) et 10 mbar (10³ Pa).

L'accéléromètre est emprisonné dans la première cavité 300a à une pression strictement supérieure à la pression de la troisième cavité 300c. L'absence de portion d'un matériau getter 305 pouvant adsorber les autres gaz 311 dans la première cavité 300a participe à l'écart de pression entre la première cavité 300a et la troisième cavité 300c. La pression résultante dans la première cavité 300a est par exemple comprise entre 10 mbar (10³ Pa) et 1 bar (10⁵ Pa). Par conséquent, en fonctionnement, l'accéléromètre est plus amorti que l'accéléromètre additionnel.

Des résultats sont donnés en Tableau 1, en lien avec un volume de cavité égale à 34.10⁶ µm³, un matériau chargé en germanium déposé par IBD, une deuxième couche en aluminium, une température de chauffage T_{C} pendant l'étape de scellement égale à 425 °C, pendant une durée de 30 minutes, un matériau getter comprenant majoritairement du titane activé pendant l'étape de scellement. En première colonne, la surface de la cavité constituée par la portion de matériau chargé est donnée relativement à une surface de référence S₀. La deuxième colonne indique la présence (« oui ») ou l'absence (« non ») d'une portion de matériau getter dans la cavité. La troisième colonne indique un facteur de qualité en unité arbitraire d'un taux d'amortissement d'un résonateur placé dans la cavité. La quatrième colonne donne la pression à l'intérieur de la cavité à l'issue du chauffage. Ces résultats montrent que trois pressions différentes dans trois cavités distinctes ont été obtenues avec le procédé d'encapsulation collectif de l'invention.

**Tableau 1**

| **Surface paroi** | **Matériau getter** | **Q** | **Pression** |
|---|---|---|---|
| S_{O} | Oui | 11 000 | 0,1 mbar (10 Pa) |
| S₀ + 37.10³ µm² | Oui | 5 000 | 1 mbar (100 Pa) |
| S₀ | Non | 800 | 10 mbar (10³ Pa) |

La quantité de gaz noble libérée par une portion d'un matériau apte à libérer un gaz noble contenu dans le matériau par chauffage peut être caractérisée de la façon suivante. On enferme hermétiquement sous vide, par exemple dans une ampoule, la portion de surface connue. On chauffe puis on refroidit la portion afin de libérer le gaz noble. On mesure alors la pression Pₐ dans l'ampoule, par exemple à l'aide d'un vacuomètre à friction. Connaissant le volume V_{A} de l'ampoule, il est possible de prédire la pression P_{C} pour un volume V_{C} de cavité quelconque. Par exemple, par application de la loi des gaz parfait, P_{C} = P_{A}V_{A}/V_{C}. L'opération peut être répétée pour des surfaces de portions et des températures de chauffage différentes. Une surface de portion peut alors être déterminée pour un volume de cavité donnée, ceci afin d'atteindre une pression cible dans la cavité. La pression dans la cavité est fonction de la surface de portion rapportée au volume de la cavité, c'est-à-dire au rapport de la surface de la portion sur le volume de la cavité.

En lien avec les figures 4A à 4E, il va être décrit plusieurs configurations possibles au moment de l'étape de scellement, correspondant à la situation de la figure 3A, ceci afin d'illustrer le grand nombre de possibilités offertes par le procédé de l'invention. Seules les différences par rapport aux conditions qui ont conduit à la situation de la figure 3A seront explicitement décrites. Il apparaîtra à la personne du métier que chacune des différences d'une configuration peut être combinée avec une différence d'une autre configuration ou une caractéristique du procédé décrit en lien avec les figures 1A, 1B, 2A, 2B, 3A et 3B.

En figure 4A, la deuxième couche est aussi en un matériau apte à libérer un gaz noble contenu dans le matériau par chauffage. Une quantité de gaz noble 310 est alors également libérée depuis une surface de chacune des première, deuxième et troisième portions complémentaires 205a, 205b, 205c à l'intérieur des première, deuxième et troisième cavités 300a, 300b, 300c respectives, lors du chauffage. Cette variante du procédé de l'invention permet par exemple de libérer une quantité plus importante de gaz noble 310 lorsqu'il est souhaitable d'augmenter la taille d'une cavité, ou de libérer des gaz additionnels ne pouvant pas être incorporés dans la première couche.

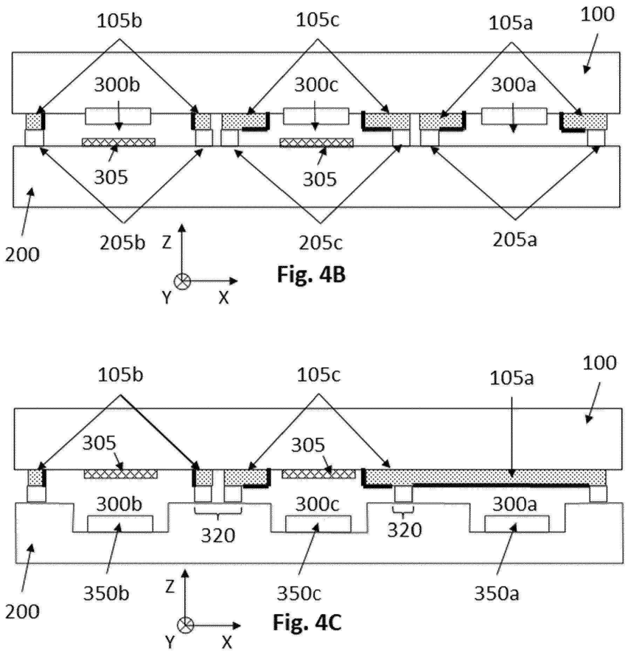

En figure 4B, on n'a pas gravé d'évidements 210 dans le capot 200 pour obtenir des première, deuxième et troisième cavités 300a, 300b, 300c de plus faibles volumes, et ainsi augmenter la pression dans les première, deuxième et troisième cavités 300a, 300b, 300c. La structure d'encapsulation 1 est également plus compacte. La troisième surface 301c est ici égale à la première surface 301a. La pression dans la première cavité 300a est strictement supérieure à la pression dans la troisième cavité 300c du fait de l'absence de portion d'un matériau getter 305 dans la première cavité 300a et donc de la présence d'autres gaz 311 chimiquement actif.

En figure 4C, la première couche et la deuxième couche n'ont pas été gravées dans une région destinée à être une région inter-cavités 320 entre la première cavité 300a et la troisième cavité 300c, ainsi cette région inter-cavités 320 est dépourvue d'espace 315. Ainsi, une puce comprenant les premier et troisième dispositifs microélectroniques 350a, 350c est plus compact après découpe. Ici, les première et troisième portions 105a, 105c et les première portions complémentaires 205a, 205c ont par définition chacune une extrémité localisée dans une surface fictive médiane de la région inter-cavités 320, orthogonale au plan (X, Y). La première portion 105a recouvre complètement une paroi supérieure de la première cavité 300a, ainsi le débordement est maximal. Les premier, deuxième et troisième dispositifs microélectroniques 350a, 350b, 350c ont été formés chacun dans un évidement 210 du capot 200. Les portions de matériau getter 305 ont été formées sur le substrat 100.

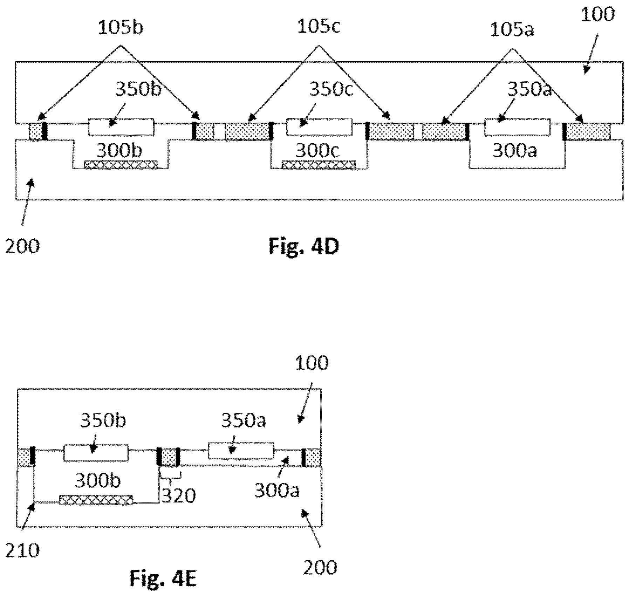

En figure 4D, le capot 200 est en silicium, le matériau chargé comprend essentiellement de l'or et le scellement est un scellement par alliage eutectique de silicium et d'or (AuSi). Il n'est alors pas nécessaire de former les première, deuxième et troisième portions complémentaires 205a, 205b, 205c et l'étape de la figure 2A peut être omise. Lors du report de l'étape de la figure 3A, les première, deuxième et troisième portions 105a, 105b, 105c sont mises en contact direct avec la deuxième face 202 du capot 200. Par conséquent, les première, deuxième et troisième surfaces 301a, 301b, 301c sont sensiblement égales. La deuxième portion 105b est agencée de sorte à délimiter une surface de la première face 101 supérieure strictement supérieure à une surface de la première face 101 délimitée par la troisième portion 105c, les évidements 210 respectifs des deuxième et troisième cavités 300b ayant des dimensions identiques par ailleurs. Ainsi, le volume de la deuxième cavité 300b est supérieur strictement au volume de la troisième cavité 300c et, par conséquent la pression dans la deuxième cavité 300b est strictement inférieur au volume de la troisième cavité 300c. La structure d'encapsulation 1 résultante est également plus compacte. Alternativement, la première portion 105a et/ou la troisième portion 105c peut être en partie suspendue au-dessus d'un évidement 210 afin de définir un débordement et ainsi accroître la première surface 301a et/ou la troisième surface 301c.

En figure 4E, le scellement est le même qu'en figure 4D, mais un autre type de scellement pourrait être utilisé. Ici, on a formé un premier dispositif microélectronique 350a et un deuxième dispositif microélectronique 350b dans et/ou sur le substrat 100. Un évidement 210 a été gravé dans le capot 200, destiné à constituer une paroi de la deuxième cavité 300b. Une surface de la deuxième face 202 du capot 200 destinée à constituer une paroi de la première cavité 300a est protégée de la gravure de l'évidement 210. Ainsi, le volume de la deuxième cavité 300b est strictement supérieur au volume de la première cavité 300a, et la pression dans la deuxième cavité 300b est strictement inférieure à la pression dans la première cavité 300a, d'autant plus que la deuxième cavité 300b est pourvue de la portion de matériau getter 305. Tout comme en figure 4D, les première et deuxième surfaces 301a, 301b sont par ailleurs sensiblement égales.

Des modes de réalisation particuliers viennent d'être décrits. Différentes variantes et modifications apparaîtront à l'homme du métier. Il est notamment possible de former un évidemment à la fois dans le capot 200 et dans le substrat 100 pour obtenir, par exemple, une cavité de volume plus important, et donc possiblement un vide plus poussé. Il est également possible de former l'une quelconque des première, deuxième et troisième portions 105a, 105b, 105c sur des flancs et/ou un fond d'un évidement 210 du capot 200 ou du substrat 100 par PVD, IBD ou IBS. Il est aussi possible de former certaines portions parmi les première, deuxième et troisième portions 105a, 105b, 105c et les première, deuxième et troisième portions complémentaires 205a, 205b, 205c en matériau chargé et les autres avec un autre matériau, il suffit pour cela, par exemple de déposer une couche additionnelle après l'étape de la figure 1A et/ou 2A d'un matériau adapté pour l'étape de scellement, ne contenant pas forcément de gaz noble. Ainsi, par exemple, la première portion 105a et la deuxième portion complémentaire 205b peuvent comprendre du gaz noble, alors que la première portion complémentaire 205a et la deuxième portion 105b en sont dépourvues. De même, il est possible de réaliser les premier, deuxième et troisième dispositifs microélectroniques 350a, 350b, 350c indifféremment et indépendamment sur le substrat 100 ou sur le capot 200.

Les modes de réalisation décrits sont relatifs à la cointégration d'accéléromètres et de gyroscopes, mais l'invention s'applique à tous types de dispositifs de la microélectronique nécessitant d'être encapsulés, comme par exemple les bolomètres.

## Revendications

1. Procédé de fabrication d'une structure d'encapsulation (1) comprenant une première cavité (300a) et une deuxième cavité (300b), toutes deux hermétiques, le procédé comportant :
∘une étape de formation sur un substrat (100) d'une première portion (105a) d'un matériau apte à libérer un gaz noble contenu dans le matériau par chauffage, destinée à constituer une paroi de la première cavité (300a),
∘ une étape de formation d'une deuxième portion (105b) du matériau sur le substrat (100) ou sur un capot (200), destinée à constituer une paroi de la deuxième cavité (300b),
∘ une étape de scellement du substrat (100) au capot (200) pour former et fermer hermétiquement sous une pression commune, chacune des première et deuxième cavités (300a, 300b),
∘ une étape de chauffage de la première et deuxième cavités (300a, 300b) pour libérer le gaz noble contenu dans le matériau,
le procédé étant **caractérisé en ce que** :
∘ la première portion (105a) et la deuxième portion (105b) participent au scellement du substrat (100) au capot (200) lors de l'étape de scellement,
∘ la paroi de la première cavité (300a) constituée par la première portion (105a) a une première surface (301a) rapportée au volume de la première cavité (300a) strictement supérieure à une deuxième surface (301b) de la paroi de la deuxième cavité (300b) constituée par la deuxième portion (105b) rapportée au volume de la deuxième cavité (300b).

2. Procédé de fabrication selon la revendication 1, dans lequel l'étape de scellement est réalisée par un alliage eutectique ou par thermocompression, et comprend l'étape de chauffage.

3. Procédé de fabrication selon la revendication 1 ou 2, dans lequel l'étape de scellement est effectuée sous un vide poussé de pression inférieure à 0,1 Pa, préférentiellement inférieure à 0,001 Pa.

4. Procédé de fabrication selon l'une quelconque des revendications 1 à 3, dans lequel l'étape de formation de la première portion (105a) comprend un dépôt de type PVD ou IBD en présence d'un gaz porteur de même nature que le gaz noble.

5. Procédé de fabrication selon la revendication 1, dans lequel la deuxième portion (105b) est formée sur le substrat (100), en même temps que la formation de la première portion (105a).

6. Procédé de fabrication selon la revendication 1, comprenant en outre une étape de formation d'une portion d'un matériau de type getter non évaporable (305) sur le substrat (100) ou le capot (200), destinée à constituer une paroi de la deuxième cavité (300b), et la portion de matériau getter (305) est activé lors de l'étape de chauffage.

7. Procédé de fabrication selon les revendications 5 et 6 d'une structure d'encapsulation (1) comprenant en outre une troisième cavité (300c) hermétique, dans lequel une troisième portion (105c) du matériau est formée sur le substrat (100), en même temps que la première portion (105a) et la deuxième portion (105b) lors de l'étape de formation, de façon à ce que la troisième portion (105c) constitue une paroi de la troisième cavité (300c) ayant une troisième surface (301c) comprise strictement entre la première surface (301a) et la deuxième surface (301b), la troisième portion (105c) participant au scellement du substrat (100) au capot (200) lors de l'étape de scellement.

8. Procédé de fabrication selon l'une quelconque des revendications précédentes, dans lequel le matériau est choisi parmi le germanium (Ge), l'or (Au), un alliage d'aluminium et de silicium (AlSi) et un alliage d'aluminum et de cuivre (AlCu).

9. Procédé de fabrication selon l'une quelconque des revendications précédentes, comprenant en outre, préalablement à l'étape de scellement, une étape de creusement d'un évidement (210) dans le substrat (100) et/ou le capot (200) destiné à constituer des parois de la première et/ou la deuxième cavité (300a, 300b).

10. Procédé de fabrication selon l'une quelconque des revendications précédentes comprenant en outre, préalablement à l'étape de scellement, une étape de réalisation d'un premier dispositif microélectronique (350a) dans et/ou sur le substrat (100) et/ou le capot (200) destiné à être emprisonné dans la première cavité (300a), et une étape de réalisation d'un deuxième dispositif microélectronique (350b) dans et/ou sur le substrat (100) et/ou le capot (200) destiné à être dans la deuxième cavité (300b).

11. Procédé de fabrication selon la revendication 10 dépendante des revendications 6 ou 7, dans lequel, le premier dispositif microélectronique (350a) est un accéléromètre et le deuxième dispositif microélectronique (350b) est un gyroscope.

12. Procédé de fabrication selon la revendication 11 dépendante de la revendication 7, comprenant en outre, préalablement à l'étape de scellement, une étape de réalisation d'un accéléromètre dans et/ou sur le substrat et/ou le capot destiné à être emprisonné dans la troisième cavité (300c).

## Patentansprüche

1. Verfahren zur Herstellung einer Kapselstruktur (1), die einen ersten Hohlraum (300a) und einen zweiten Hohlraum (300b) umfasst, die beide hermetisch sind, wobei das Verfahren Folgendes umfasst:
∘ einen Schritt des Bildens eines ersten Abschnitts (105a) eines Materials, das ausgelegt ist, ein im Material enthaltenes Edelgas durch Erwärmung freizusetzen, auf einem Substrat (100), das dazu bestimmt ist, eine Wand des ersten Hohlraums (300a) zu bilden,
∘ einen Schritt des Bildens eines zweiten Abschnitts (105b) des Materials auf dem Substrat (100) oder auf einer Abdeckung (200), der dazu ausgelegt ist, eine Wand des zweiten Hohlraums (300b) zu bilden,
∘ einen Schritt des Versiegelns des Substrats (100) mit der Abdeckung (200), um jeden der ersten und zweiten Hohlräume (300a, 300b) unter gemeinsamem Druck zu bilden und hermetisch zu verschließen,
∘ einen Schritt des Erwärmens des ersten und zweiten Hohlraums (300a, 300b) zum Freisetzen des im Material enthaltenen Edelgases,
wobei das Verfahren **dadurch gekennzeichnet ist, dass**:
∘ der erste Abschnitt (105a) und der zweite Abschnitt (105b) beim Versiegeln des Substrats (100) an der Abdeckung (200) während des Versiegelungsschritts beteiligt sind,
∘ die Wand des ersten Hohlraums (300a), die aus dem ersten Abschnitt (105a) besteht, eine erste Oberfläche (301a) im Verhältnis zum Volumen des ersten Hohlraums (300a) aufweist, die wesentlich größer ist als eine zweite Oberfläche (301b) der Wand des zweiten Hohlraums (300b), die aus dem zweiten Abschnitt (105b) im Verhältnis zum Volumen des zweiten Hohlraums (300b) besteht.

2. Herstellungsverfahren nach Anspruch 1, wobei der Versiegelungsschritt durch eine eutektische Legierung oder durch Thermokompression ausgeführt wird und den Heizschritt umfasst.

3. Herstellungsverfahren nach Anspruch 1 oder 2, wobei der Versiegelungsschritt unter einem Hochdruckvakuum von weniger als 0,1 Pa, vorzugsweise weniger als 0,001 Pa, durchgeführt wird.

4. Herstellungsverfahren nach einem der Ansprüche 1 bis 3, wobei der Schritt des Bildens des ersten Abschnitts (105a) eine Ablagerung vom Typ PVD oder IBD in Gegenwart eines Trägergases derselben Art wie das Edelgas umfasst.

5. Herstellungsverfahren nach Anspruch 1, wobei der zweite Abschnitt (105b) gleichzeitig mit der Bildung des ersten Abschnitts (105a) auf dem Substrat (100) gebildet wird.

6. Herstellungsverfahren nach Anspruch 1, weiter umfassend einen Schritt des Bildens eines Abschnitts eines nicht verdunstungsfähigen Getter-Materials (305) auf dem Substrat (100) oder der Abdeckung (200), der dazu bestimmt ist, eine Wand des zweiten Hohlraums (300b) zu bilden, und der Abschnitt des Getter-Materials (305) während des Heizschritts aktiviert wird.

7. Herstellungsverfahren nach den Ansprüchen 5 und 6 einer Kapselstruktur (1), weiter umfassend einen dritten hermetischen Hohlraum (300c), wobei ein dritter Abschnitt (105c) des Materials auf dem Substrat (100) zusammen mit dem ersten Abschnitt (105a) und dem zweiten Abschnitt (105b) während des Bildungsschritts gebildet wird, so dass der dritte Abschnitt (105c) eine Wand des dritten Hohlraums (300c) mit einer dritten Oberfläche (301c) bildet, die wesentlich zwischen der ersten Oberfläche (301a) und der zweiten Oberfläche (301b) liegt, wobei der dritte Abschnitt (105c) an der Versiegelung des Substrats (100) mit der Abdeckung (200) während des Versiegelungsschritts beteiligt ist.

8. Herstellungsverfahren nach einem der vorhergehenden Ansprüche, wobei das Material aus Germanium (Ge), Gold (Au), einer Aluminium-Silizium-Legierung (AISi) und einer Aluminium-Kupfer-Legierung (AlCu) ausgewählt ist.

9. Herstellungsverfahren nach einem der vorhergehenden Ansprüche, weiter umfassend, vor dem Versiegelungsschritt, einen Schritt des Eingrabens einer Aussparung (210) in das Substrat (100) und/oder in der Abdeckung (200), die dazu bestimmt ist, Wände des ersten und/oder zweiten Hohlraums (300a, 300b) auszubilden.

10. Herstellungsverfahren nach einem der vorhergehenden Ansprüche, das weiter vor dem Versiegelungsschritt einen Schritt des Herstellens einer ersten mikroelektronischen Vorrichtung (350a) in und/oder auf dem Substrat (100) und/oder der Abdeckung (200), die in dem ersten Hohlraum (300a) eingeschlossen werden soll, und einen Schritt des Herstellens einer zweiten mikroelektronischen Vorrichtung (350b) in und/oder auf dem Substrat (100) und/oder der Abdeckung (200), die in dem zweiten Hohlraum (300b) eingeschlossen werden soll, umfasst.

11. Herstellungsverfahren nach Anspruch 10, abhängig von Anspruch 6 oder 7, wobei die erste mikroelektronische Vorrichtung (350a) ein Beschleunigungsmesser und die zweite mikroelektronische Vorrichtung (350b) ein Gyroskop ist.

12. Herstellungsverfahren nach Anspruch 11, abhängig von Anspruch 7, weiter umfassend, vor dem Versiegelungsschritt, einen Schritt des Herstellens eines Beschleunigungsmessers in und/oder auf dem Substrat und/oder der Abdeckung, der in den dritten Hohlraum (300c) eingeschlossen werden soll.

## Claims

1. A method for manufacturing a packaging structure (1) comprising a first cavity (300a) and a second cavity (300b), both hermetic, the method including:
∘ a step of forming over a substrate (100) a first portion (105a) of a material capable of releasing a noble gas contained in the material by heating, intended to form a wall of the first cavity (300a),
∘ a step of forming a second portion (105b) of the material over the substrate (100) or over a cover (200), intended to form a wall of the second cavity (300b),
∘ a step of sealing the substrate (100) to the cover (200) so as to form and hermetically close under a common pressure each of the first and second cavities (300a, 300b),
∘ a step of heating the first and second cavities (300a, 300b) to release the noble gas contained in the material,
the method being **characterized in that**:
∘ the first portion (105a) and the second portion (105b) contribute to sealing of the substrate (100) to the cover (200) during the sealing step,
∘ the wall of the first cavity (300a) formed by the first portion (105a) has a first surface (301a) divided by the volume of the first cavity (300a) strictly greater than a second surface (301b) of the wall of the second cavity (300b) formed by the second portion (105b) divided by the volume of the second cavity (300b).

2. The manufacturing method according to claim 1, wherein the sealing step is carried out using an eutectic alloy or by thermocompression, and comprises the heating step.

3. The manufacturing method according to claim 1 or 2, wherein the sealing step is performed under a high vacuum at a pressure lower than 0.1 Pa, preferably lower than 0.001 Pa.

4. The manufacturing method according to any one of claims 1 to 3, wherein the step of forming the first portion (105a) comprises a PVD or IBD type deposition in the presence of a carrier gas of the same nature as the noble gas.

5. The manufacturing method according to claim 1, wherein the second portion (105b) is formed over the substrate (100), at the same time as the first portion (105a) is formed.

6. The manufacturing method according to claim 1, further comprising a step of forming a portion of a non-evaporable getter-type material (305) over the substrate (100) or the cover (200), intended to form a wall of the second cavity (300b), and the getter material portion (305) is activated during the heating step.

7. The method according to claims 5 and 6 for manufacturing a packaging structure (1) further comprising a third hermetic cavity (300c), wherein a third portion (105c) of the material is formed over the substrate (100), at the same time as the first portion (105a) and the second portion (105b) during the formation step, so that the third portion (105c) forms a wall of the third cavity (300c) having a third surface (301c) strictly comprised between the first surface (301a) and the second surface (301b), the third portion (105c) contributing to sealing of the substrate (100) to the cover (200) during the sealing step.

8. The manufacturing step according to any one of the preceding claims, wherein the material is selected from among germanium (Ge), gold (Au), an aluminum and silicon alloy (AlSi) and an aluminum and copper alloy (AlCu).

9. The manufacturing method according to any one of the preceding claims, further comprising, prior to the sealing step, a step of digging a void (210) in the substrate (100) and/or the cover (200) intended to form walls of the first and/or second cavity (300a, 300b).

10. The manufacturing method according to any one of the preceding claims, further comprising, prior to the sealing step, a step of making a first microelectronic device (350a) in and/or over the substrate (100) and/or the cover (200) intended to be trapped in the first cavity (300a), and a step of making a second microelectronic device (350b) in and/or over the substrate (100) and/or the cover (200) intended to be in the second cavity (300b).

11. The manufacturing method according to claim 10 in combination with claims 6 or 7, wherein, the first microelectronic device (350a) is an accelerometer and the second microelectronic device (350b) is a gyroscope.

12. The manufacturing method according to claim 11 in combination with claim 7, further comprising, prior to the sealing step, a step of making an accelerometer in and/or over the substrate and/or the cover intended to be trapped in the third cavity (300c).
